(19) Europäisches Patentamt
European Patent Office
Office européen des brevets

(11) **EP 4 113 279 A1**

(12) **EUROPEAN PATENT APPLICATION**

(43) Date of publication:
**04.01.2023 Bulletin 2023/01**

(21) Application number: **22181964.2**

(22) Date of filing: **29.06.2022**

(51) International Patent Classification (IPC):
**G06F 7/523** $^{(2006.01)}$     **G06F 7/535** $^{(2006.01)}$

(52) Cooperative Patent Classification (CPC):
**G06F 7/523; G06F 7/535**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.06.2021  GB 202109460**

(71) Applicant: **Imagination Technologies Limited Kings Langley, Hertfordshire WD4 8LZ (GB)**

(72) Inventors:
• **ROSE, Thomas**
  **Kings Langley, WD4 8LZ (GB)**
• **ELLIOTT, Sam**
  **Kings Langley, WD4 8LZ (GB)**

(74) Representative: **Slingsby Partners LLP**
  **1 Kingsway**
  **London WC2B 6AN (GB)**

(54) **CONSTANT MULTIPLICATION BY DIVISION**

(57)     A fixed logic circuit configured to determine one or more of the most significant bits of the multiplication operation $a * x$, where $a$ is an integer constant, $x$ is an integer variable in the range 0 to $2^m$ - 1, and $m$ is a positive integer, the fixed logic circuit comprising: division logic configured to determine a predetermined number of one or more most significant bits of the result of the division operation:

$$\left\lfloor \frac{2^i x}{q} \right\rfloor$$

where $i$ is the minimum positive value which satisfies:

$$\frac{2}{(2^i m\ldots}$$

$$q = \left\lfloor \frac{2^i}{a} \right\rfloor$$

and output logic configured to provide the one or more most significant bits of the result of the division operation as the respective one or more most significant bits of the multiplication operation $a * x$.

FIGURE 1

**Description**

**BACKGROUND**

This invention relates to a fixed logic circuit for performing multiplication at least in part by division and to a method of deriving a fixed logic circuit for performing such multiplication.

When designing integrated circuits, logic is often required to perform addition, subtraction, multiplication and division.

Multiplication operations are typically implemented in hardware using a multiplication array (such as an AND or BOOTH array) and performing an array reduction scheme using full or half adders. Such implementations are capable of efficiently calculating the complete multiplication result but the most significant bits of the result are generated after the least significant bits of the result. This is because the output of calculations to generate the least significant bits must be carried through for use in the calculations performed to generate the most significant bits.

**SUMMARY**

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

There is provided a fixed logic circuit configured to determine one or more of the most significant bits of the multiplication operation $a * x$, where $a$ is an integer constant, $x$ is an integer variable in the range 0 to $2^m$ - 1, and $m$ is a positive integer, the fixed logic circuit comprising:

division logic configured to determine a predetermined number of one or more most significant bits of the result of the division operation:

$$\left\lfloor \frac{2^i x}{q} \right\rfloor$$

where $i$ is the minimum positive value which satisfies:

$$\frac{2^i}{(2^i \bmod a)} > a * (2^m - 1) + 1$$

and:

$$q = \left\lfloor \frac{2^i}{a} \right\rfloor ;$$

and
output logic configured to provide the one or more most significant bits of the result of the division operation as the respective one or more most significant bits of the multiplication operation $a * x$.

The one or more of the most significant bits of the multiplication operation may be a contiguous set including the most significant bit.

The one or more most significant bits of the result of the division operation may be a contiguous set including the most significant bit of that result.

The division logic may be configured to perform iterative division.

Each iteration performed by the division logic may be configured to provide one or more contiguous most significant bits of the multiplication operation, starting at the most significant bit.

The division logic may be configured to use a binary positional numeral system and to provide a single bit of the multiplication operation at each iteration.

The division logic may be configured to use a positional numeral system other than a binary positional numeral system so as to provide a predefined plurality of bits of the multiplication operation at each iteration.

The positional numeral system may be one of RADIX 4, RADIX 8 or RADIX 16.

The division logic may comprise an array of full and/or half subtractors and comparators arranged to perform iterative division.

The division logic may be configured to calculate fewer than the number of bits required to fully represent the integer output of the division operation up to the radix point.

The predetermined number of one or more most significant bits of the result of the division operation may be fewer than the number of bits required to fully represent the integer output of the division operation up to the radix point.

The division logic may be configured to perform division according to a restoring, non-performing restoring, non-restoring, or SRT division algorithm.

The fixed logic circuit may further comprise multiplication logic configured to determine a predetermined number of one or more least significant bits of the result of the multiplication operation $a * x$; and the output logic may be configured to combine the predetermined number of one or more most significant bits of the result of the division operation with the predetermined number of one or more least significant bits of the result of the multiplication operation so as to provide an output for the multiplication operation $a * x$.

There is provided an integrated circuit comprising the fixed logic circuit.

There is provided a method of deriving a hardware representation of a fixed logic circuit configured to determine one or more of the most significant bits of the multiplication operation $a * x$, where $a$ is a predefined constant integer, $x$ is an integer variable in the range 0 to $2^m$ - 1, and $m$ is a positive integer, the method comprising:

identifying the minimum positive value of $i$ which satisfies:

$$\frac{2^i}{(2^i \bmod a)} > a * (2^m - 1) + 1$$

using the minimum positive value of $i$, deriving a hardware representation of a fixed logic circuit configured to determine one or more most significant bits of the result of the division operation:

$$\left\lfloor \frac{2^i x}{q} \right\rfloor$$

where

$$q = \left\lfloor \frac{2^i}{a} \right\rfloor$$

and

configuring the hardware representation to provide the one or more most significant bits of the result of the division operation as the respective one or more most significant bits of the multiplication operation $a * x$.

There is provided a fixed logic circuit generated according to this method. There is provided computer readable code configured to cause this method to be performed when the code is run. There is provided a computer readable storage medium having encoded thereon the computer readable code.

There is provided a method of manufacturing, using an integrated circuit manufacturing system, the fixed logic circuit.

There is provided a method of manufacturing, using an integrated circuit manufacturing system, the fixed logic circuit, the method comprising:

processing, using a layout processing system, a computer readable description of the fixed logic circuit so as to generate a circuit layout description of an integrated circuit embodying the fixed logic circuit; and

manufacturing, using an integrated circuit generation system, the fixed logic circuit according to the circuit layout description.

There is provided an integrated circuit definition dataset that, when processed in an integrated circuit manufacturing system, configures the integrated circuit manufacturing system to manufacture the fixed logic circuit.

There is provided a computer readable storage medium having stored thereon a computer readable description of the fixed logic circuit that, when processed in an integrated circuit manufacturing system, causes the integrated circuit manufacturing system to manufacture an integrated circuit embodying the fixed logic circuit.

There is provided a computer readable storage medium having stored thereon a computer readable description of the fixed logic circuit which, when processed in an integrated circuit manufacturing system, causes the integrated circuit manufacturing system to:

process, using a layout processing system, the computer readable description of the fixed logic circuit so as to generate a circuit layout description of an integrated circuit embodying the fixed logic circuit; and

manufacture, using an integrated circuit generation system, the fixed logic circuit according to the circuit layout description.

There is provided an integrated circuit manufacturing system configured to manufacture the fixed logic circuit.

There is provided an integrated circuit manufacturing system comprising:

a non-transitory computer readable storage medium having stored thereon a computer readable description of the fixed logic circuit;

a layout processing system configured to process the computer readable description so as to generate a circuit layout description of an integrated circuit embodying the fixed logic circuit; and an integrated circuit generation system configured to manufacture the fixed logic circuit according to the circuit layout description.

The above features may be combined as appropriate, as would be apparent to a skilled person, and may be combined with any of the aspects of the examples described herein.

## BRIEF DESCRIPTION OF THE DRAWINGS

Examples will now be described in detail with reference to the accompanying drawings in which:

Figure 1 is a schematic diagram of a fixed logic circuit configured in accordance with the principles described herein to calculate the $r$ most significant values of a multiplication by a constant operation.

Figure 2 is a schematic illustration of a binary division operation.

Figure 3 is a schematic diagram of a fixed logic circuit configured in accordance with the principles described herein to calculate a multiplication by a constant operation by performing a division and multiplication operations.

Figure 4 illustrates the advantages of implementing multiplication by division to generate the first r most significant bits of a multiplication operation.

Figure 5 is a flowchart illustrating a method of deriving a fixed logic circuit according to principles described herein.

Figure 6 is a flowchart illustrating a method of deriving a fixed logic circuit according to principles described herein.

Figure 7 is a schematic diagram of an integrated circuit manufacturing system.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

## DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Embodiments will now be described by way of example only.

For values of equivalent magnitude, fixed logic for performing division is typically slower and larger than fixed logic for performing multiplication. For example, implementing the operation $\frac{p}{q}$ in a binary logic circuit is typically slower and larger than a binary logic circuit configured to perform the operation $p * q$ for constants $p$ and $q$. The inventors have recognised that it can nonetheless be advantageous to implement an operation multiplying an input value by a constant in hardware as a division operation. By identifying a suitable division operation in the manner described herein, fixed hardware configured to perform the division operation can provide one or more of the most significant bits of a multiplication operation more quickly and/or in a smaller circuit than fixed hardware configured to perform the multiplication operation.

The multiplication of an input variable $x$ by a constant integer $a$ may be represented by an equivalent division operation by a constant integer $q$ as follows:

$$a * x = \left\lfloor \frac{2^i * x}{q} \right\rfloor \qquad (1)$$

The introduction of $2^i$ ensures that there is a solution to the above equation in which $q$ is an integer. In binary logic multiplication by $2^i$ represents a left shift by $i$ bits. Advantageously and as will be described below, the value of $i$ is selected in order to minimise the size of $q$ so as to minimise the size of the fixed logic hardware implementing the division operation.

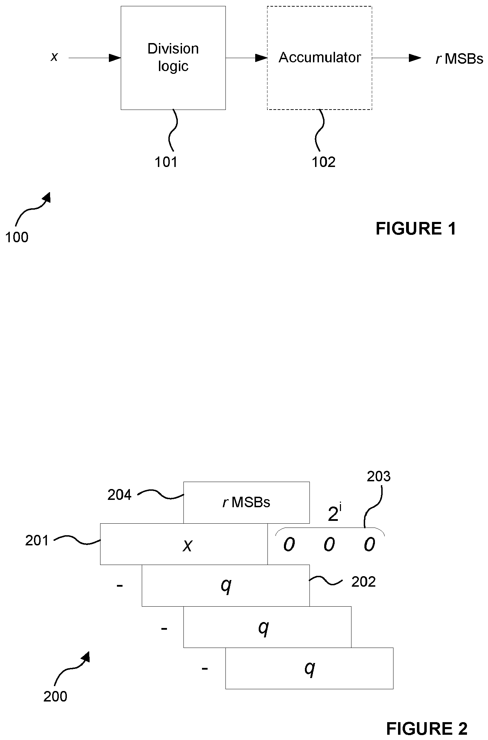

A fixed logic circuit 100 for performing the division by a constant integer of equation (1) above is shown in Figure 1. The fixed logic circuit comprises division logic 101 which is configured to perform the division operation of equation (1) at least in part so as to provide $r$ most significant bits of the result of the division operation. The fixed logic circuit may further comprise an accumulator 102 (e.g. a set of hardware registers) for storing the output of the division operation performed at the division logic. The division logic is configured to perform iterative division (i.e. "slow" or "long" division) which provides one or more bits of the output of the division operation at each iteration. The nature of such division is that the output of the division operation is provided starting at its most significant bit. For division logic configured to perform division using the RADIX 2 (binary) number system, each iteration provides a single bit of the output of the division operation.

The division logic 101 is configured to perform the division operation $\frac{2^i * x}{q}$. The multiplication by $2^i$ represents a left shift by $i$ bits. No logic is required to implement a shift by a fixed value, which may be performed through appropriate hardwiring at the fixed logic 100 to left shift the binary digits calculated at the division logic by $i$ bits. Similarly, no logic is required to implement the floor operation of equation (1) which may be achieved by truncation of the output of the division logic at the radix point. In practice, the division logic 101 may be configured to calculate the $r$ most significant bits of the result of the division operation such that those bits do not represent the result beyond the radix point. Typically, the division logic will be configured to calculate fewer than the number of bits required to fully represent the integer output of the division operation up to the radix point. For example, if the integer output of the full division operation represented by equation (1) is $t$ bits then the r bits calculated by the division logic may satisfy $r < t$. So that the division logic 101 provides a $t$ bit output, the least significant output bits which are not calculated at the division logic may be inferred - e.g. by setting the least significant bits to zero, which can be achieved without logic by appropriate hardwiring at the fixed logic 100.

Note that not all of the string of zeros representing the left shift by $2^i$ need be implemented in hardware: only a sufficient number of the zeros need be present/implied in the hardware such that the first $r$ most significant bits of the output can be calculated.

The division logic 101 may be configured to calculate the $r$ most significant bits of the division operation represented in equation (1) according to any suitable algorithm. For example, the division logic may be configured to perform restoring, non-performing restoring, non-restoring, or SRT division. Fixed logic circuits for performing such division algorithms are well known in the art.

The division logic 101 may comprise a division array configured to perform the division operation. Such a division array may comprise a plurality of subtractors and comparators arranged so as to calculate the r most significant bits of the division operation represented in equation (1) according to a division algorithm selected at design time. It is envisaged that at design time a reduction scheme is employed to reduce the size of the division array as far as possible.

The division logic is configured to perform division of input variable $x$ by a constant divisor $q$ which is predetermined at design time according to the principles described herein.

Figure 2 schematically illustrates the "long" division and shift operations 200 performed by the division logic in a binary implementation. The figure is representative of the functions performed by the division logic but it will be appreciated that the particular operations performed at the fixed logic circuit will depend on the particular division algorithm used and the particular logic circuits implemented to effect that algorithm.

In Figure 2, the input variable $x$ 201 is left shifted by $i$ bits which is represented by the set 203 of $i$ bits of value 0. As is well known, division by the divisor $q$ 202 in a binary implementation may be performed in an iterative manner. At a first iteration, the divisor 202 is subtracted from the input variable 201 at the appropriate bit position. At subsequent iterations, the divisor 202 is subtracted at the appropriate bit position from the remainder formed at the previous iteration. Subtraction may be performed in hardware by appropriate subtractor logic. As is known in the art for such "long" division algorithms, the appropriate bit position at which the divisor 202 is subtracted at each iteration may be established by comparison of the size of divisor $q$ to the size of the dividend $x$. Such comparison may be performed in hardware by appropriate comparator logic.

At each iteration, an output bit of the division operation is generated, starting at the most significant bit. In this binary example, the division logic is configured to perform $r$ iterations until the $r$ most significant output bits 204 are generated. As each bit is generated it may be stored at accumulator 104.

It is envisaged that division logic 101 could use a positional numeral system other than RADIX 2 (binary) so as to provide more than one output bit per iteration. For example, a RADIX 4 implementation can provide 2 bits at a time, a RADIX 8 (octal) implementation can provide 3 bits at a time, and a RADIX 16 (hexadecimal) implementation can provide 4 bits at a time. It can be advantageous to configure the division logic to use a positional numeral system which provides the required number of $r$ most significant bits in a single iteration. This provides a large but fast hardware implementation. As is known in the art, division using positional numeral systems other than RADIX 2 can still be implemented using binary logic circuits. The division logic 101 may be a binary logic circuit.

In order to minimise the complexity, latency and size of a fixed logic implementation of division logic 101, it is advantageous to select a minimum value of $q$ which satisfies equation (1) over the full range of $x$ in the multiplication operation $a * x$ of equation (1) which is to be performed at least in part by the division logic. This optimal value of $q$ will now be identified for a given constant integer $a \in \mathbb{N}$ and an unsigned $m$-bit variable input $x \in [0, 2^m - 1]$ where $m \in \mathrm{N}$. The present technique need not be used where $a$ is an integer power of 2 since that represents a bit shift in binary logic and so may be trivially performed in a hardware without using division logic as described herein. We therefore exclude the possibility that $a$ is a positive integer power of 2.

Equation (1) above states:

$$a * x = \left\lfloor \frac{2^i * x}{q} \right\rfloor \qquad (1)$$

In order to minimise the complexity, latency and size of a fixed logic implementation of division logic 101, we need to identify the smallest $q \in \mathbb{N}$ such that a constant $i \in \mathbb{N}$ exists for equation (1) over the full range of $x$.

Equation (1) can be restated as:

$$a * x \leq \frac{2^i * x}{q} < a * x + 1 \qquad (2)$$

This is because

$$\frac{2^i * x}{q} := \left\lfloor \frac{2^i * x}{q} \right\rfloor + \frac{(2^i * x) \bmod q}{q} = a * x + \frac{(2^i * x) \bmod q}{q}$$

And since

$$\frac{(2^i * x) \bmod q}{q} \in [0,1)$$

This means $\dfrac{2^i * x}{q}$ lies between integers $a * x$ and $a * x + 1$.

Taking away $a * x$ from equation (2) and factoring gives:

$$0 \leq \left(\frac{2^i}{q} - a\right) * x < 1$$

Both inequalities most hold for all values of $x \in [0, 2^m - 1]$. Consider the lower inequality first:

$$0 \leq \left(\frac{2^i}{q} - a\right) * x$$

For $x = 0$, this is trivially met for any $\frac{2^i}{q}$ value, but for the other values of $x > 0$ we can divide through by $x$ to give:

$$0 \leq \left(\frac{2^i}{q} - a\right) \qquad (3)$$

Equality of equation (3) implies that $a * q = 2^i$, which implies both $a, q$ are positive powers of 2. But $a$ is restricted not to be a positive power of 2 and so:

$$a < \frac{2^i}{q}$$

$$\frac{1}{a} > \frac{q}{2^i} \qquad (4)$$

Looking at the second inequality and now knowing that $0 < \left(\frac{2^i}{q} - a\right)$ :

$$\left(\frac{2^i}{q} - a\right) * x < 1 \qquad (5)$$

Plotting $f(x) = \left(\frac{2^i}{q} - a\right) * x$ would give a straight line with a positive gradient $\left(\frac{2^i}{q} - a\right)$, so its maximum value is when $x$ is its maximum value $2^m - 1$. In this case $f(2^m - 1) = \left(\frac{2^i}{q} - a\right) * (2^m - 1)$. If this value is below 1, then the equality will be true for all values of $x \in [0, 2^m - 1]$.

Equation (5) therefore gives:

$$\frac{2^i}{q} < \frac{1}{(2^m - 1)} + a$$

$$\frac{q}{2^i} > \frac{1}{a} - \frac{1}{a^2(2^m - 1) + a} \qquad (6)$$

Combining inequalities (4) and (6) gives an open interval in which $\frac{q}{2^i}$ is to be found:

$$\frac{1}{a} > \frac{q}{2^i} > \frac{1}{a} - \frac{1}{a^2(2^m-1)+a} \qquad (7)$$

$$\text{i.e. } \frac{q}{2^i} \in \left( \frac{1}{a} - \frac{1}{a^2(2^m-1)+a}, \frac{1}{a} \right)$$

For a given value of $i \in$ N, the positive integer value of $q$ for which $\frac{q}{2^i}$ is closest to $\frac{1}{a}$ whilst $\frac{1}{a} > \frac{q}{2^i}$ is still true is:

$$q = \left\lfloor \frac{2^i}{a} \right\rfloor$$

This is because:

$$\frac{q}{2^i} = \frac{\left\lfloor \frac{2^i}{a} \right\rfloor}{2^i} < \frac{\left( \frac{2^i}{a} \right)}{2^i} = \frac{1}{a}$$

And the next integer is:

$$q = \left\lceil \frac{2^i}{a} \right\rceil$$

Because

$$\frac{q}{2^i} = \frac{\left\lceil \frac{2^i}{a} \right\rceil}{2^i} > \frac{\left( \frac{2^i}{a} \right)}{2^i} = \frac{1}{a}$$

The value of $q$ is therefore:

$$q = \left\lfloor \frac{2^i}{a} \right\rfloor \qquad (8)$$

This can be established as follows. Consider the positive integer multiples of $\frac{1}{2^i}$ starting from $i = 0,1,2,..$ which lie in the interval $\left( \frac{1}{a} - \frac{1}{a^2(2^m-1)+a}, \frac{1}{a} \right)$. None exist for $i = 0$, since $\left( \frac{1}{a} - \frac{1}{a^2(2^m-1)+a}, \frac{1}{a} \right)$ is contained in the interval $(0,1)$ because $a > 1$ and $a^2(2^m - 1) + a > a$.

Find the first value of $i$ such that a positive integer multiple exists (this value of $i$ always exists no matter how small the interval, as these values cover the number line evenly with a spacing of width $\frac{1}{2^i}$ which can be made arbitrarily small). This integer will be unique and odd and will therefore be $q = \left\lfloor \frac{2^i}{a} \right\rfloor$ of equation (8).

The minimal value of $i$, defined as $i_{min}$, gives the smallest value of $q = \left\lfloor \frac{2^{i_{min}}}{a} \right\rfloor$. This is the smallest value $q$ can take.

In order to find $i_{min}$ and setting $q = \left\lfloor \frac{2^i}{a} \right\rfloor$ in equation (7) above:

$$\frac{1}{a} > \frac{\left\lfloor \frac{2^i}{a} \right\rfloor}{2^i} > \frac{1}{a} - \frac{1}{a^2(2^m - 1) + a}$$

It follows from the definition of the floor function that:

$$\left\lfloor \frac{2^i}{a} \right\rfloor := \frac{2^i - (2^i \bmod a)}{a}$$

And so

$$\frac{\frac{2^i - (2^i \bmod a)}{a}}{2^i} > \frac{1}{a} - \frac{1}{a^2(2^m - 1) + a}$$

$$\frac{1}{a} - \frac{(2^i \bmod a)}{a * 2^i} > \frac{1}{a} - \frac{1}{a^2(2^m - 1) + a}$$

$$-\frac{(2^i \bmod a)}{a * 2^i} > -\frac{1}{a^2(2^m - 1) + a}$$

$$\frac{(2^i \bmod a)}{2^i} < \frac{1}{a * (2^m - 1) + 1}$$

$$\frac{2^i}{(2^i \bmod a)} > a * (2^m - 1) + 1 \qquad (9)$$

The minimum positive value of $i := i_{min}$ is that value of $i$ which satisfies equation (9). The minimum positive value of $q$ is then given by:

$$q = \left\lfloor \frac{2^{i_{min}}}{a} \right\rfloor \qquad (10)$$

This value of $q$ ensures that $a * x = \left\lfloor \frac{2^i * x}{q} \right\rfloor$ for all integer inputs $x \in [0, 2^m - 1]$. For the vast majority of cases $i_{min} \in [m + \lceil \ln_2(a) \rceil, m + 2 * \lceil \ln_2(a) \rceil]$ and so $q$ is an unsigned integer with integer bit width in $[m, m + \lceil \ln_2(a) \rceil]$,

In order to calculate the first $r$ most significant bits of the multiplication operation $a * x$, the division logic 101 is configured to calculate the first $r$ most significant bits of the division operation $\left\lfloor \frac{2^i * x}{q} \right\rfloor$. In order to minimise the complexity, latency and size of a fixed logic implementation of the division logic, it is advantageous to select that $i = i_{min}$ and $q =$

$$\left\lceil \frac{2^{i_{min}}}{a} \right\rceil$$ . As described above, the division logic is configured to perform iterative division, with a sufficient number of iterations being performed to provide the required $r$ most significant bits. Preferably the division logic is not configured to provide more than $r$ most significant bits. This minimises the complexity, latency and size of a fixed logic implementation.

In some implementations, the division logic 101 will be configured to provide the most significant bit only ($r = 1$). In some implementations, the division logic 101 will be configured to provide all of the bits of the division operation expressed in equation (1), although such embodiments will typically be larger and slower than conventional fixed logic configured to directly perform the multiplication operation $a * x$.

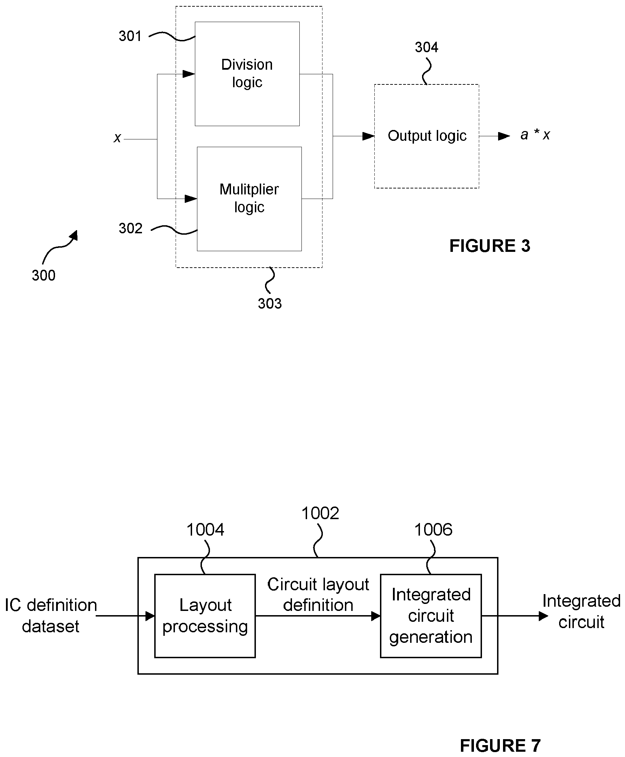

In some implementations, division and multiplication fixed logic may be provided together to calculate the complete output of the multiplication operation $a * x$. Figure 3 shows a fixed logic circuit 300 which comprises fixed logic 303 including division logic 301 configured in accordance with the principles described herein so as to generate the first $r$ most significant bits of the multiplication $a * x$, and multiplier logic 302 configured to generate the remaining least significant bits of the multiplication $a * x$. The division and multiplier logic may provide their output to output logic 304 (e.g. an accumulator or register to store the output bits and concatenate the r most significant bits with the remaining least significant bits).

For an output of bit length $t$ bits, the multiplier logic may generate $t - r$ least significant bits. This approach can provide a very fast (although typically large) fixed logic circuit for calculating $a * x$. This is because the division logic generates the bits of the output starting from the most significant bit and the multiplier logic generates the bits of the output starting from the least significant bit. Since neither division nor multiplier logic generate the full $t$ bits of the result of $a * x$, the fixed logic circuit is as fast as the slowest of the division and multiplier logic to generate its portion of the output.

The multiplier logic is configured to perform the multiplication of input variable $x$ by integer constant $a$ such that the least significant bits of the output are provided first. Fixed logic for performing such multiplication operations are well known in the art. The multiplier logic the binary logic circuit may comprise a multiplier array having a plurality of full and/or half adders arranged to calculate the first $t - r$ least significant bits of the multiplication operation. It is envisaged that at design time a reduction scheme may be employed to reduce the size of the multiplier array as far as possible.

Typically multiplier logic is faster and smaller than division logic for a given output bit length. It is can therefore be advantageous for the multiplier logic 302 to generate a greater number of bits than the division logic 301. The proportion of output bits calculated by each of the division and multiplier logic may be optimised at design time so as to minimise the latency and/or chip area of fixed logic circuit 300.

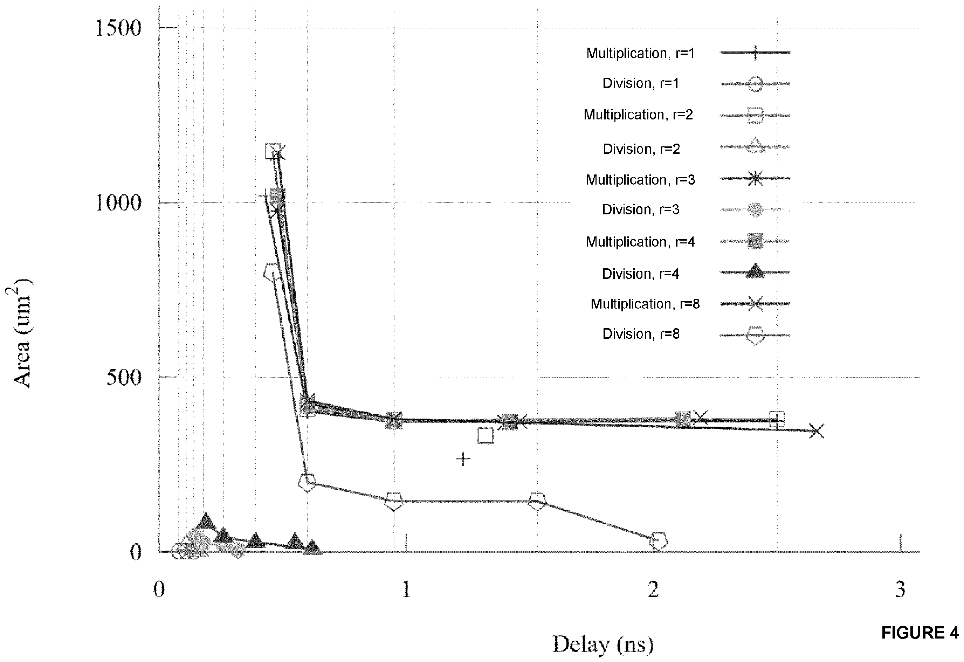

Figure 4 illustrates the advantages of using division logic configured in accordance with the principles described herein to generate the first $r$ most significant bits of a multiplication operation $1431655765 * x$. The bottom axis of the plot in Figure 4 represents delay in ns and the left-hand axis represents area in square micrometres. The plot shows a series of lines comparing the size and speed of performing a constant multiplication operation using a 16nm multiplier array versus using 16nm division logic configured to perform constant iterative division to calculate the top 1, 2, 3, 4, and 8 most significant bits of the result of the constant multiplication operation. The constant multiplication operation was performed for an input variable $x$ of length 32 bits, and a constant $a = 1431655765$, such that value of $i_{min} = 64$ and the length of the output was 63 bits.

Lines identified as "Multiplication" lines identified in the key connect points in the plot representing the operational delay and area consumed by multiplier logic designs generated by conventional logic synthesis software for calculating the $r$ most significant bits of the constant multiplication operation $a * x$. "Division" lines identified in the key connect points in the plot representing the operational delay and area consumed by division logic designs as described herein for calculating the $r$ most significant bits of the constant multiplication operation $a * x$. The r value of each line is identified in the key in the figure.

As can be seen from the plot, logic designs implemented using the division logic taught herein are substantially faster and smaller in terms of the area of integrated circuit consumed. This is the case up to $r$ values of around 8, and, for large enough delays, the division logic can be smaller than the equivalent multiplication logic even up to around $r = 14$. When a larger number of most significant bits is required, it is faster and requires less circuit area to use conventional multiplier logic to calculate the $r$ most significant bits of $1431655765 * x$.

Method of IC design

Fixed logic hardware implementations of the division logic described herein may be determined by suitable software. Typically, integrated circuits are initially designed using software (e.g. Synopsys® Design Compiler) that generates a logical abstraction of the desired integrated circuit. Such an abstraction is generally termed register-transfer level or RTL. Once the logical operation of the integrated circuit has been defined, this can be used by synthesis software (e.g. Synopsys® IC Compiler) to create representations of the physical integrated circuit. Such representations can be defined in high level hardware description languages, for example Verilog or VHDL and, ultimately, according to a gate-level description of the integrated circuit.

Logic for performing division by a constant can be readily introduced into an integrated circuit at design time. However, the design software used for designing integrated circuits will almost invariably provide the functionality using logic for performing generic division - i.e. logic for performing division by a divisor specified at runtime. Such logic is complex and consumes a significant area of integrated circuit. It can therefore be advantageous to, where logic for performing multiplication by a constant fraction is required, configure design software to use logic optimised for calculating the first $r$ bits of the division by a constant $\left\lfloor \dfrac{2^i * x}{q} \right\rfloor$, where $i, q$ may take the minimum $i$ and $q$ values identified herein.

It is advantageous if software for designing an integrated circuit is configured to, on being required to implement fixed logic for calculating the first $r$ most significant bits of a multiplication by a constant operation, implement the operation as a division by a constant in accordance with the design principles described herein. This could be by introducing into the integrated circuit design RTL defining division by a constant $\left\lfloor \dfrac{2^i * x}{q} \right\rfloor$ where the values of $i$ and $q$ could take their minimum values as taught herein. The design of an integrated circuit can be effected according to the rules embodied in the design software at a data processing device executing the design software (such as a workstation or server).

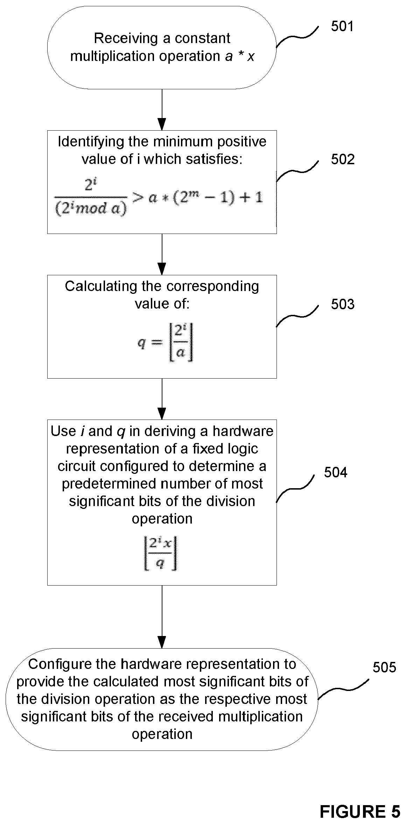

A method of deriving a hardware representation of a fixed logic circuit in accordance with the principles set out herein is illustrated in the flowchart of Figure 5. At 501, a multiplication by a constant operation $a * x$ is received, where $a$ is a predefined constant integer and $x$ is an integer variable in the range 0 to $2^m - 1$ (where $m$ is a positive integer). At 502, the minimum positive value of $i$ is identified which satisfies:

$$\frac{2^i}{(2^i \bmod a)} > a * (2^m - 1) + 1$$

At 503, the resulting value of $i$ is then used to calculate the corresponding value of:

$$q = \left\lfloor \frac{2^i}{a} \right\rfloor$$

At 504, the values of $i$ and $q$ are then used in deriving a hardware representation for a fixed logic circuit configured to determine a predetermined number of one or more most significant bits of the result of the division operation:

$$\left\lfloor \frac{2^i x}{q} \right\rfloor$$

The hardware representation is configured at 505 to provide the predetermined $r$ most significant bits of the result of the division operation as the respective one or more most significant bits of the multiplication operation $a * x$.

The method of Figure 5 could be implemented in program code, such as RTL design software. For example, on a user of the software requiring the $r$ most significant bits of a multiplication by a constant operation, the RTL design software could be configured to implement the operation using RTL defining the division logic for calculating the first $r$ most significant bits of the division operation:

$$\left\lfloor \frac{2^i x}{q} \right\rfloor$$

where $i$ and $q$ take the values described herein.

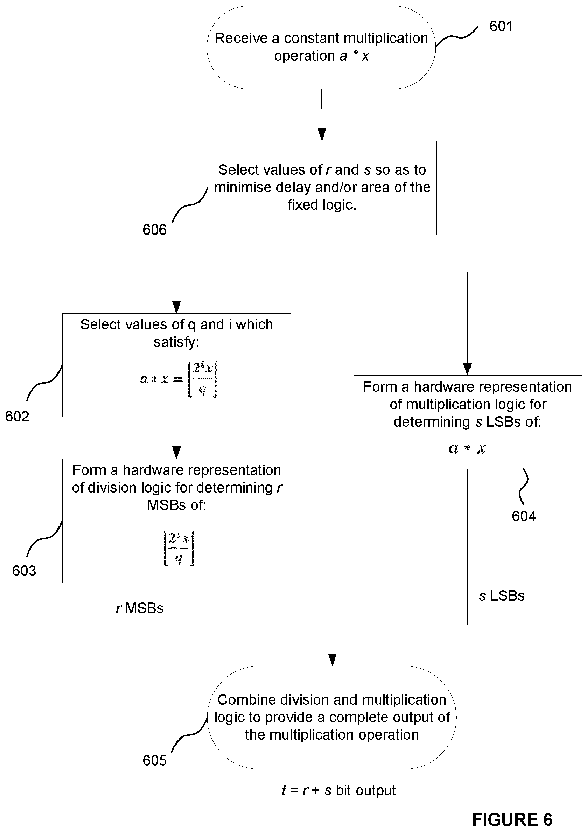

A method of deriving a hardware representation of a fixed logic circuit comprising both division logic configured in accordance with the principles set out herein and multiplier logic (e.g. as shown in Figure 3) is illustrated in the flowchart of Figure 6. This can provide fast fixed logic circuits for calculating the complete output of a multiplication operation $a * x$ (e.g. the complete set of $t$ bits of the integer result up to its radix point).

At 601, a multiplication by a constant operation $a * x$ is received, where $a$ is a predefined constant integer and $x$ is an integer variable in the range 0 to $2^m - 1$ (where $m$ is a positive integer). Hardware representations of fixed logic for performing the multiplication operation as a combination of division and multiplication operations are then derived.

The number of bits $r$, $s$ provided by the division and multiplier logic are selected at 606, as discussed in more detail below. A hardware representation of division logic is derived at 602 and 603. Values of $q, i$ are selected at 602 so as to satisfy equation (1) above. For example, $i$ may take the value which satisfies equation (9) above, and so $q$ may take the value specified in equation (10). The selected values of $q, i$ are used to form 603 a hardware representation of division logic for determining the $r$ most significant bits of the division operation:

$$\left\lfloor \frac{2^i x}{q} \right\rfloor$$

By equation (1) above, the $r$ most significant bits of this division operation are also the $r$ most significant bits of the multiplication operation to be implemented in the fixed logic circuit. The hardware representation of division logic may be derived in the manner described above with respect to Figure 5.

A hardware representation of multiplication logic for determining the $s$ least significant bits of the multiplication operation is formed at 604. The hardware representation of multiplication logic may be derived in any suitable manner - for example, in accordance with known algorithms for designing multiplication logic. The multiplication logic could be selected from a library of multiplier designs according to the desired properties of the fixed logic - e.g. whether the hardware is to be optimised for speed and/or size. The multiplication logic could comprise an array of logic gates - for example, an AND array or a Booth array.

At 605, the hardware representations of the division and multiplication logic are combined so as to derive fixed logic for calculating the result of the multiplication operation $a * x$. In the fixed logic, for example, the r MSBs provided by the division logic are combined with the $s$ LSBs provided by the multiplication logic so as to provide the $r + s = t$ bits of the result of the multiplication operation $a * x$ (where $t$ is the number of bits of the integer result up to the radix point). Note that one or more of 602, 603, 604 and 605 may be performed together. Combining the division and multiplier logic at 605 may comprise defining an accumulator or set of registers in the hardware representation which is arranged to receive the bits provided by the division and multiplier logic such that, in use, the accumulator/registers provides the result of the multiplication operation $a * x$.

The number of bits $r$, $s$ provided by the division and multiplier logic are selected at 606. In some examples $r$, $s$ could be predetermined (e.g. specified by a designer to chip design software implementing the method of Figure 6). In the example shown in Figure 6, the number of bits $r$, $s$ are selected so as to optimise the fixed logic circuit - e.g. the number of bits $r$, $s$ may be selected so as to minimise the delay and/or area of the fixed logic. Division logic is typically slower than multiplication logic to produce a given number of output bits. It can therefore be advantageous to configure the division logic to provide fewer bits than the multiplication logic - i.e. that $r < s$. Optimisation (e.g. through modelling the expected speed/area of logic for various values $r$, $s$) may be performed to identify values for $r$, $s$ which minimise one or both of the speed and delay of the fixed logic circuit derived in accordance with the principles set out herein.

The method of Figure 6 could be implemented in program code, such as RTL design software. For example, on a user of the software requiring the $r$ most significant bits of a multiplication by a constant operation, the RTL design software could be configured to implement the operation using RTL defining the division logic for calculating the first $r$ most significant bits of the division operation:

$$\left\lfloor \frac{2^i x}{q} \right\rfloor$$

where $i$ and $q$ take the values described herein.

The hardware representations referred to herein could be register-transfer level (RTL) representations, high-level circuit representations such as Verilog or VHDL, or lower-level representations such as OASIS or GDSII. A hardware representation of a binary logic circuit can be provided (typically as part of a larger-scale chip design) for fabrication into an integrated circuit. For example, a low-level representation of an IC could be provided directly to a foundry for fabrication of the specified integrated circuit, or RTL could be provided to an intermediate chip designer who would themselves design a low-level representation of an IC from the RTL for provision to a foundry.

The fixed logic of Figures 1 and 3 are shown as comprising a number of functional blocks. This is schematic only and is not intended to define a strict division between different logic elements of such entities. Each functional block may be provided in any suitable manner. It is to be understood that intermediate values described herein as being formed by fixed logic need not be physically generated by the fixed logic at any point and may merely represent logical values which conveniently describe the processing performed by the fixed logic between its input and output.

The fixed logic described herein may be embodied in hardware on an integrated circuit. The fixed logic may be binary logic circuitry.

The asterisk '*' symbol is used herein to denote multiplication.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a fixed logic circuit as described herein. An integrated circuit definition dataset may be, for example, an integrated circuit description.

Therefore, there may be provided a method of manufacturing, at an integrated circuit manufacturing system, a fixed logic circuit as described herein. Furthermore, there may be provided an integrated circuit definition dataset that, when processed in an integrated circuit manufacturing system, causes the method of manufacturing a fixed logic circuit to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

A computer readable description of a fixed logic circuit may be a hardware representation of a fixed logic circuit as described herein.

An example of processing an integrated circuit definition dataset at an integrated circuit manufacturing system so as to configure the system to manufacture a fixed logic circuit will now be described with respect to Figure 7.

Figure 7 shows an example of an integrated circuit (IC) manufacturing system 1002 which is configured to manufacture a fixed logic circuit as described in any of the examples herein. In particular, the IC manufacturing system 1002 comprises a layout processing system 1004 and an integrated circuit generation system 1006. The IC manufacturing system 1002 is configured to receive an IC definition dataset (e.g. defining a fixed logic circuit as described in any of the examples herein), process the IC definition dataset, and generate an IC according to the IC definition dataset (e.g. which embodies a fixed logic circuit as described in any of the examples herein). The processing of the IC definition dataset configures the IC manufacturing system 1002 to manufacture an integrated circuit embodying a fixed logic circuit as described in any of the examples herein.

The layout processing system 1004 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 1004 has determined the circuit layout it may output a circuit layout definition to the IC generation system 1006. A circuit layout definition may be, for example, a circuit layout description.

The IC generation system 1006 generates an IC according to the circuit layout definition, as is known in the art. For example, the IC generation system 1006 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 1006 may be in the form of computer-readable code which the IC generation system 1006 can use to form a suitable mask for use in generating an IC.

The different processes performed by the IC manufacturing system 1002 may be implemented all in one location, e.g. by one party. Alternatively, the IC manufacturing system 1002 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a fixed logic circuit without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 7 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 7, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

**Claims**

**1.** A fixed logic circuit configured to determine one or more of the most significant bits of the multiplication operation *a* ∗ *x,* where *a* is an integer constant, *x* is an integer variable in the range 0 to $2^m$ - 1, and *m* is a positive integer, the fixed logic circuit comprising:

division logic configured to determine a predetermined number of one or more most significant bits of the result of the division operation:

$$\left\lfloor \frac{2^i x}{q} \right\rfloor$$

where *i* is the minimum positive value which satisfies:

$$\frac{2^i}{(2^i \bmod a)} > a * (2^m - 1) + 1$$

and:

$$q = \left\lfloor \frac{2^i}{a} \right\rfloor;$$

and
output logic configured to provide the one or more most significant bits of the result of the division operation as the respective one or more most significant bits of the multiplication operation *a* ∗ *x.*

2. A fixed logic circuit as claimed in claim 1, wherein the one or more of the most significant bits of the multiplication operation are a contiguous set including the most significant bit.

3. A fixed logic circuit as claimed in claim 1 or 2, wherein the one or more most significant bits of the result of the division operation are a contiguous set including the most significant bit of that result.

4. A fixed logic circuit as claimed in any preceding claim, wherein the division logic is configured to perform iterative division, wherein each iteration performed by the division logic is configured to provide one or more contiguous most significant bits of the multiplication operation, starting at the most significant bit.

5. A fixed logic circuit as claimed in claim 4, wherein the division logic is configured to use a binary positional numeral system and to provide a single bit of the multiplication operation at each iteration.

6. A fixed logic circuit as claimed in claim 4, wherein the division logic is configured to use a positional numeral system other than a binary positional numeral system so as to provide a predefined plurality of bits of the multiplication operation at each iteration

7. A fixed logic circuit as claimed in any preceding claim, wherein the division logic comprises an array of full and/or half subtractors and comparators arranged to perform iterative division.

8. A fixed logic circuit as claimed in any preceding claim, wherein the division logic is configured to calculate fewer than the number of bits required to fully represent the integer output of the division operation up to the radix point.

9. A fixed logic circuit as claimed in any preceding claim, wherein the predetermined number of one or more most significant bits of the result of the division operation is fewer than the number of bits required to fully represent the integer output of the division operation up to the radix point.

10. An integrated circuit comprising the fixed logic circuit of any preceding claim.

11. A method of deriving a hardware representation of a fixed logic circuit configured to determine one or more of the most significant bits of the multiplication operation $a * x$, where $a$ is a predefined constant integer, $x$ is an integer variable in the range 0 to $2^m - 1$, and $m$ is a positive integer, the method comprising:

identifying the minimum positive value of $i$ which satisfies:

$$\frac{2^i}{(2^i \bmod a)} > a * (2^m - 1) + 1$$

using the minimum positive value of $i$, deriving a hardware representation of a fixed logic circuit configured to determine one or more most significant bits of the result of the division operation:

$$\left\lfloor \frac{2^i x}{q} \right\rfloor$$

where

$$q = \left\lfloor \frac{2^i}{a} \right\rfloor$$

and

configuring the hardware representation to provide the one or more most significant bits of the result of the division operation as the respective one or more most significant bits of the multiplication operation $a * x$.

12. A fixed logic circuit generated according to the method of claim 11.

13. Computer readable code configured to cause the method of claim 11 to be performed when the code is run.

14. A method of manufacturing, using an integrated circuit manufacturing system, a fixed logic circuit as claimed in any of claims 1 to 10.

15. An integrated circuit definition dataset that, when processed in an integrated circuit manufacturing system, configures the integrated circuit manufacturing system to manufacture a fixed logic circuit as claimed in any of claims 1 to 10.

x → | Division logic | → | Accumulator | → r MSBs

101    102

100

**FIGURE 1**

204 — r MSBs    $2^i$    203

201 — x    0  0  0

−    q    202

−    q

−    q

200

**FIGURE 2**

FIGURE 3

FIGURE 7

EP 4 113 279 A1

FIGURE 4

Receiving a constant
multiplication operation $a * x$

501

Identifying the minimum positive
value of i which satisfies:

$$\frac{2^i}{(2^i \bmod a)} > a * (2^m - 1) + 1$$

502

Calculating the corresponding
value of:

$$q = \left\lfloor \frac{2^i}{a} \right\rfloor$$

503

Use $i$ and $q$ in deriving a hardware
representation of a fixed logic
circuit configured to determine a
predetermined number of most
significant bits of the division
operation

$$\left\lfloor \frac{2^i x}{q} \right\rfloor$$

504

Configure the hardware representation to
provide the calculated most significant bits of
the division operation as the respective most
significant bits of the received multiplication
operation

505

FIGURE 5

Receive a constant multiplication
operation $a * x$ — 601

Select values of $r$ and $s$ so as to
minimise delay and/or area of the
fixed logic.
606

Select values of q and i which
satisfy:

$$a * x = \left\lfloor \frac{2^i x}{q} \right\rfloor$$

602

Form a hardware representation
of division logic for determining $r$
MSBs of:

$$\left\lfloor \frac{2^i x}{q} \right\rfloor$$

603

$r$ MSBs

Form a hardware representation
of multiplication logic for
determining $s$ LSBs of:

$$a * x$$

604

$s$ LSBs

Combine division and multiplication
logic to provide a complete output of
the multiplication operation

605

$t = r + s$ bit output

**FIGURE 6**

Europäisches
Patentamt
European
Patent Office
Office européen
des brevets

# EUROPEAN SEARCH REPORT

Application Number

EP 22 18 1964

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SCHULTE M J ET AL: "Truncated multiplication with correction constant Ýfor DSP", VLSI SIGNAL PROCESSING, VI, 1993., ÝWORKSHOP ON VELDHOVEN, NETHERLANDS 20-22 OCT. 1993, NEW YORK, NY, USA,IEEE, 20 October 1993 (1993-10-20), pages 388-396, XP010140388, DOI: 10.1109/VLSISP.1993.404467 ISBN: 978-0-7803-0996-8 * section 1 * | 1-15 | INV. G06F7/523 G06F7/535 |
| A | SINGH TONJAM GUNENDRA ET AL: "Constant Multiplication and its Existing Techniques", INTERNATIONAL JOURNAL OF SCIENTIFIC AND RESEARCH PUBLICATIONS (IJSRP) , vol. 9, no. 1 1 January 2019 (2019-01-01), pages p8594-2250, XP055889864, DOI: 10.29322/IJSRP.9.01.2019.p8594 Retrieved from the Internet: URL:http://www.ijsrp.org/research-paper-0119/ijsrp-p8594.pdf * section II. 1. * | 1-15 | |
| A | US 2014/280410 A1 (ROSE THOMAS [GB]) 18 September 2014 (2014-09-18) * paragraphs [0001] - [0040] * | 1-15 | TECHNICAL FIELDS SEARCHED (IPC)  G06F |

The present search report has been drawn up for all claims

| Place of search | Date of completion of the search | Examiner |
|---|---|---|
| Munich | 15 November 2022 | Prins, Leendert |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
 
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 18 1964

15-11-2022

| Patent document cited in search report | | Publication date | Patent family member(s) | | Publication date |
|---|---|---|---|---|---|
| US 2014280410 | A1 | 18-09-2014 | US | 2014280410 A1 | 18-09-2014 |
| | | | US | 2017262258 A1 | 14-09-2017 |

For more details about this annex : see Official Journal of the European Patent Office, No. 12/82